# EUROPEAN PATENT APPLICATION

(11) **EP 4 632 803 A1**
(43) Date of publication of application: **15.10.2025**
(21) Application number: 25168283.7
(22) Date of filing: 03.04.2025
(51) Int. Cl.: H01L 23/00, H01L 23/495, H01L 23/373, H01L 23/433

(54) **SEMICONDUCTOR DEVICE**

(30) Priority: 08.04.2024 JP 2024062202; 04.02.2025 JP 2025017028
(71) Applicant: DENSO CORPORATION, Kariya-city, Aichi-pref., 448-8661 (JP); MIRISE Technologies Corporation, Nisshin-shi, Aichi-ken 470-0111 (JP)
(72) Inventor: IWASHIGE, Tomohito, Nisshin-shi, Aichi-ken, 470-0111 (JP); KANDA, Yoshihiko, Nisshin-shi, Aichi-ken, 470-0111 (JP)
(74) Representative: Kuhnen & Wacker Patent- und Rechtsanwaltsbüro PartG mbB

(57) **Abstract**

A semiconductor device includes: a semiconductor element (3) as a first member; a second member (1, 4) connected to the semiconductor element; and a bonding material (2) that bonds the semiconductor element and the second member. The bonding material has: a stress relaxation layer (22) made of metal wires (221); and a sintered joint layer (23) bonded to the semiconductor element or the second member. The metal wire has a length equal to or greater than a predetermined value in a thickness direction (D1) defined to connect the semiconductor element and the second member.

## Description

The present disclosure relates to a semiconductor device in which a semiconductor element is bonded to another member by a bonding material having a metal wire.

A power semiconductor element such as a power MOSFET and another member such as a heat spreader are bonded with each other via a bonding material, in a semiconductor device. MOSFET is an abbreviation for Metal Oxide Semiconductor Field Effect Transistor. JP 6639394 B2 describes a bonding material used in this type of semiconductor device. The bonding material is a multilayer composite film in which solid silver foil is disposed between two layers of sintered silver nanoparticles, to bond different components together. The sintered silver nanoparticles are sintered when pressurized and heated.

In a bonding material, a sintered joint layer that bonds two members is formed by sintering silver nanoparticles. Since the bonding material has high thermal conductivity, from the standpoint of improving heat dissipation, the bonding material is suitable for a power module that uses a power semiconductor element.

However, the sintered joint layer of the bonding material has a high elastic modulus. If a difference in linear expansion coefficient with the bonding material is equal to or greater than a predetermined value, the internal stress increases, causing cracks.

DE 102020107515A1 describes a bonding material composed of copper nanowires. The bonding material made of copper nanowires bonds different components together under pressure and heat. However, as a result of investigation by the inventors, the copper nanowires are put in a state similar to a sintered body if two components are joined using the bonding material made of the copper nanowires. Then, cracks will occur during the manufacturing process of the semiconductor device. This is believed to be due to the fact that copper has a higher elastic modulus than silver.

In view of the above, the present disclosure aims to provide a semiconductor device in which a semiconductor element and another component are bonded with a bonding material, to simultaneously ensure the bonding with the bonding material while suppressing the occurrence of cracks in the bonding material, thereby improving reliability.

According to one aspect of the present disclosure, a semiconductor device includes: a semiconductor element as a first member; a second member connected to the semiconductor element; and a bonding material that bonds the semiconductor element and the second member. The bonding material has: a stress relaxation layer made of metal wires; and a sintered joint layer bonded to the semiconductor element or the second member. The metal wire has a length equal to or greater than a predetermined value in a thickness direction defined to connect the semiconductor element and the second member.

In the semiconductor device, the semiconductor element, that is, the first member and the second member are bonded with the bonding material. The bonding material has the stress relaxation layer made of the metal wires, and the sintered joint layer bonded to the semiconductor element or the second member. The bonding material has the sintered joint layer to ensure the bonding between the semiconductor element and the second member. Further, a stress caused by the difference in linear expansion coefficient between the semiconductor element and the second member is relaxed by the stress relaxation layer made of the metal wires having the length equal to or greater than the predetermined value in the thickness direction. Therefore, the semiconductor device has an improved reliability to ensure the bonding between the semiconductor element and the second member while suppressing the occurrence of cracks caused by the difference in linear expansion coefficient between the members.

A reference numeral in parentheses attached to each component or the like indicates an example of correspondence between the component or the like and specific component or the like described in embodiments below.
FIG. 1 is a cross-sectional view showing a semiconductor device according to an embodiment.
FIG. 2A is a cross-sectional view showing a bonding material before bonding.
FIG. 2B is a diagram showing a cross-section of a bonding material before bonding with a scanning electron microscope.
FIG. 3 is a cross-sectional view showing a bonding material after bonding.
FIG. 4 is a cross-sectional view showing another configuration of a bonding material before bonding.
FIG. 5 is a cross-sectional view showing another configuration of a bonding material after bonding.
FIG. 6 is a cross-sectional view showing another configuration of a semiconductor device.
FIG. 7 is a diagram showing a region VII in FIG. 1 by a scanning electron microscope.
FIG. 8 is a diagram showing evaluation results of joint properties relative to Working Examples and Comparative Examples having a first joint structure.
FIG. 9 is an explanatory diagram for evaluation of the joint properties.
FIG. 10 is a diagram showing evaluation results of joint properties relative to Working Examples and Comparative Examples having a second joint structure.
FIG. 11 is a diagram showing a cross-section of a semiconductor element on which metal wires are formed, by a scanning electron microscope.
FIG. 12 is a simulation graph showing a relationship between a length of a metal wire of a first structure corresponding to Working Examples and a fracture mechanics parameter (J integral) related to crack propagation in a joint portion of a sintered joint layer.
FIG. 13 is a simulation graph showing a relationship between a length of a metal wire of a first structure corresponding to Working Examples and a stress (maximum principal stress) related to an initiation of an initial crack in a joint portion of a sintered joint layer.
FIG. 14 is a simulation graph showing a relationship between a thickness of a sintered joint layer of a second structure corresponding to Working Examples and a stress (maximum principal stress) related to an initiation of an initial crack in a joint portion of a sintered joint layer.

Hereinafter, embodiments of the present disclosure will be described with reference to the drawings. In the embodiments, same or equivalent parts are designated with the same reference numerals.

A semiconductor device 100 having a bonding material 2 according to an embodiment will be described.

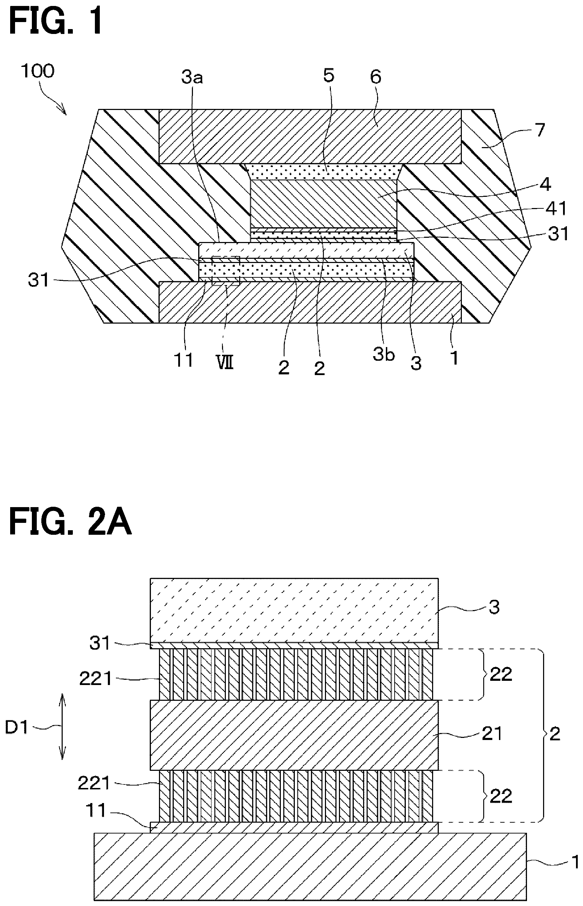

As shown in FIG. 1, the semiconductor device 100 includes a first heat spreader 1, a semiconductor element 3, a metal block 4, a solder 5, a second heat spreader 6, a sealing resin 7, and the bonding material 2. The first heat spreader 1, the semiconductor element 3, the metal block 4, and the second heat spreader 6 are stacked in this order. The semiconductor device 100 has a double-sided heat dissipation structure in which the first heat spreader 1 and the second heat spreader 6 opposite the semiconductor element 3 are exposed from the sealing resin 7. In the semiconductor device 100, the bonding material 2 bonds the semiconductor element 3 to the adjacent member, and the metal block 4 and the second heat spreader 6 are bonded together by the solder 5.

The first heat spreader 1 is a part of a lead frame made of a conductive material, for example, metal such as Cu (copper) or Fe (iron) or an alloy thereof, and is formed by press punching or the like. The first heat spreader 1 is a heat dissipation member that dissipates heat from the semiconductor element 3 during operation to the outside. One surface of the first heat spreader 1 is bonded to the semiconductor element 3 via the bonding material 2, and the other surface opposite to the one surface is exposed from the sealing resin 7. The first heat spreader 1 corresponds to a second member bonded to the semiconductor element 3, which is a first member, via the bonding material 2. The first heat spreader 1 has a terminal (not shown) that extends beyond the side surface of the sealing resin 7 and is electrically connected to the semiconductor element 3 via the terminal. The first heat spreader 1 has a covering layer 11 formed on a surface in contact with the bonding material 2. The covering layer 11 is made of a material that can be bonded to the material of a metal wire 221 to be described later, such as Cu, Ag (silver) or a Cu alloy, to make the bonding with the bonding material 2 more stable. The first heat spreader 1 may not have the covering layer 11 when being made of, for example, Cu or a Cu alloy.

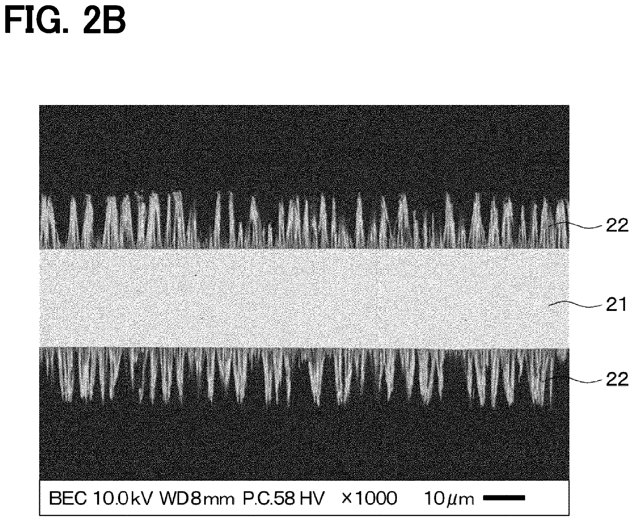

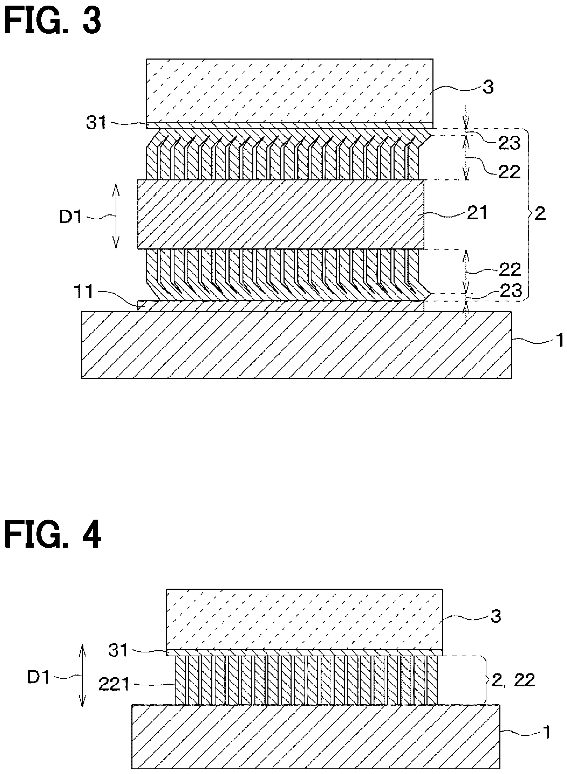

As shown in FIGS. 2A and 2B, the bonding material 2 before bonding has a metal bulk layer 21 and stress relaxation layers 22 formed on both the surfaces of the metal bulk layer 21. The bonding material 2 is positioned, for example, between the semiconductor element 3 and another member, and is pressed in the thickness direction in this state while being heated at a temperature below its melting point, thereby bonding the two members together. At this time, as shown in FIG. 3, a part of the stress relaxation layer 22 including the tip opposite to the metal bulk layer 21 is sintered with the member in contact with, forming a sintered joint layer 23.

FIG. 2A shows the bonding material 2 before bonding, in which the sintered joint layer 23 has not yet been formed. As shown in FIG. 2A, for convenience of explanation, a thickness direction D1 is defined along a thickness of the member bonded by the bonding material 2. The thickness direction D1 corresponds to, for example, a direction along the thickness of any one of the first heat spreader 1, the semiconductor element 3, the metal block 4, and the semiconductor device 100.

The metal bulk layer 21 serves as a base for the stress relaxation layer 22. The metal bulk layer 21 is a metal foil made of, for example, Cu, Al (aluminum), an FeNi (iron-nickel) alloy, or a Cu alloy such as CuMo (copper molybdenum) or CuW (copper tungsten). The metal bulk layer 21 may be made of material that can serve as a base when forming the metal wires 221 by electroplating. The metal bulk layer 21 is not limited to the material examples given above. It is more preferable that the metal bulk layer 21 is made of material having a small linear expansion coefficient. From the viewpoint of suppressing poor bonding of the bonding material 2, the volume fraction of the metal bulk layer 21 in the entire bonding material 2 is set to be, for example, 68% or less. The details will be described later.

The stress relaxation layer 22 is made of metal wires 221. The metal wire 221 is made of metal material that can be formed by electroplating, such as Cu, and has a columnar wire body extending in the thickness direction D1. The metal wires 221 form, for example, a seed layer and a patterned resist layer that partially covers the seed layer, and are grown by electroplating on a portion of the seed layer exposed from the resist layer.

As shown in FIG. 3, when the metal wire 221 is heated and pressurized, the tip end of the metal wire 221 becomes the sintered joint layer 23 bonded to another member, while the other end of the metal wire 221 adjacent to the base at the time of formation becomes the root. After the semiconductor element 3 and another member are joined, the root of the metal wire 221 remains in a wire shape, and relieves stress caused by the difference in linear expansion coefficient between the two members joined with each other. Before the bonding, the metal wire 221 is aligned along the thickness direction D1. After the bonding by applying pressure and heat, a part of the tip of the metal wire 221 becomes inclined at an angle of a predetermined value or more with respect to the thickness direction D1. For example, the root side of the metal wire 221 is vertically oriented, approximately parallel to the thickness direction D1, whereas the tip side where the sintered joint layer 23 is formed is bent and oriented at an angle of a predetermined value or more relative to the thickness direction D1. In order to relieve the above-mentioned stress and suppress the occurrence of cracks in the bonding material 2, the metal wire 221 has a length of 2.0 µm or more in the thickness direction D1 after bonding. The details will be described later. The metal wire 221 has a length on the order of micrometers, for example, but is formed by a method that allows it to be manufactured in the range of a few nanometers. The metal wire 221 can also be considered a nanowire.

The sintered joint layer 23 is formed by sintering a part of the tip of the metal wire 221 by applying pressure and heat. The sintered joint layer 23 bonds the tip of the metal wire 221 to a member in contact therewith.

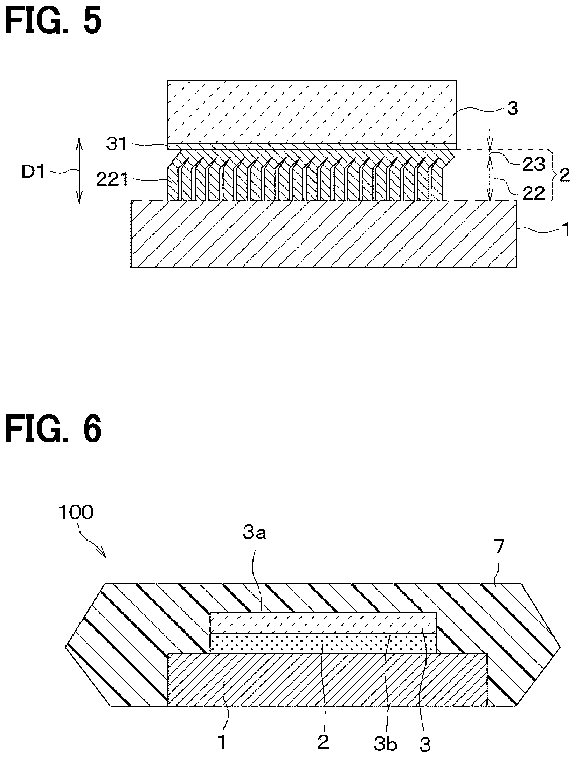

As shown in FIG. 4, the bonding material 2 may not have the metal bulk layer 21. In this case, the bonding material 2 is formed directly on the first heat spreader 1, the semiconductor element 3, and the metal block 4 by electroplating. Before bonding, the bonding material 2 has only the stress relaxation layer 22 made of the metal wires 221. Then, as shown in FIG. 5, when the bonding material 2 is pressurized and heated, a part of the tips of the metal wires 221 form the sintered joint layer 23, while the roots of the metal wires 221 remain in wire shapes. As a result, even if the bonding material 2 does not have the metal bulk layer 21, some of the metal wires 221 remain intact, thereby alleviating stress and bonding two components together. Thus, the reliability can be improved.

In the case where the metal bulk layer 21 is not included, the bonding material 2 is formed, for example, only on one of the two members to be bonded. In FIGS. 4 and 5, the metal wires 221 are formed on the first heat spreader 1 and the first heat spreader 1 and the semiconductor element 3 are joined together, but not limited to this. For example, the metal wires 221 may be formed on the semiconductor element 3. When the semiconductor element 3 and the metal block 4 are joined, the metal wires 221 may be formed on the metal block 4. Alternatively, the metal wire 221 may be formed on both of the two members to be joined. In this way, when the bonding material 2 is configured without the metal bulk layer 21, the material on which the metal wires 221 are formed can be changed as appropriate.

The semiconductor element 3 has the form of a plate having a front surface 3a and a back surface 3b, and is mainly made of a semiconductor material such as Si (silicon), SiC (silicon carbide), GaN (gallium nitride), GaO (gallium oxide), diamond, or the like. The semiconductor element 3 is, for example, a power semiconductor element such as an IGBT or a power MOSFET, and is manufactured by a predetermined semiconductor process. IGBT is an abbreviation for Insulated Gate Bipolar Transistor. The semiconductor element 3 has, for example, a gate electrode and an emitter electrode or a source electrode (not shown) formed on the front surface 3a, and a collector electrode or a drain electrode (not shown) formed on the back surface 3b. The semiconductor element 3 has the front surface 3a connected to the metal block 4 via the bonding material 2, and the back surface 3b connected to the first heat spreader 1 via the bonding material 2. The semiconductor element 3 has, for example, a covering layer 31 formed on the front surface 3a and the back surface 3b. The covering layer 31 is made of, for example, the same material as the covering layer 11, and makes the bonding with the bonding material 2 more stable.

The metal block 4 is a metal member made of a conductive material, for example, metal such as Cu or an alloy thereof, and is disposed between the semiconductor element 3 and the second heat spreader 6. The metal block 4 may be referred to as a terminal. The metal block 4 electrically connects the semiconductor element 3 and the second heat spreader 6 while maintaining a gap of a specified size or more therebetween. The metal block 4 restricts a wire (not shown) connected to the semiconductor element 3 from coming into contact with the second heat spreader 6. Similar to the first heat spreader 1, the metal block 4 corresponds to a second member bonded via the bonding material 2 to the semiconductor element 3 which serves as a first member. The metal block 4 has a smaller planar size than the semiconductor element 3 when viewed in the normal direction to the front surface 3a. The metal block 4 is disposed so that the entire area of the metal block 4 falls within the front surface 3a of the semiconductor element 3. The metal block 4 has a covering layer 41 formed on the surface facing the semiconductor element 3. The covering layer 41 is made of, for example, the same material as the covering layer 11, 31, and makes the bonding with the bonding material 2 more stable. The metal block 4 may not have the covering layer 41 if being made of, for example, Cu or a Cu alloy.

The solder 5 is made of a bonding material containing Sn (tin) as a main component, for example, and is applied to the metal block 4 or the second heat spreader 6 by a known application process. The solder 5 may be arranged, for example, by mounting a foil-like piece on the metal block 4 or the second heat spreader 6.

The second heat spreader 6 is, for example, a part of a lead frame made of the same conductive material as the first heat spreader 1, and is formed by press punching or the like. The second heat spreader 6 is located opposite to the first heat spreader 1 with the semiconductor element 3 and the metal block 4 interposed therebetween. One surface of the second heat spreader 6 is bonded to the metal block 4 via the solder 5, and the other surface opposite to the one surface is exposed from the sealing resin 7. A part of the second heat spreader 6 soldered to the metal block 4 serves as a heat sink and has a terminal (not shown).

The sealing resin 7 is made of a thermosetting resin material such as epoxy resin, and is formed by a resin molding method such as transfer molding using a die (not shown) or compression molding.

The semiconductor device 100 as a double-sided heat dissipation module has the above-described basic configuration. The semiconductor device 100 is not limited to the structure shown in FIG. 1, and may have a structure in which the semiconductor element 3 and another member are bonded by the bonding material 2. The semiconductor device 100 may be a one-sided heat dissipation module, as shown in FIG. 6, which does not have the metal block 4, the solder 5, or the second heat spreader 6. In this case, heat from the semiconductor element 3 is dissipated to the outside from the first heat spreader 1 via the bonding material 2. In the semiconductor device 100, the first heat spreader 1 may be, for example, an insulating heat dissipation circuit board such as AMB or DBC, or a Cu heat sink. The type of material joined to the semiconductor element 3 may be changed as appropriate. AMB and DBC are abbreviations for Active Metal Brazed and Direct Bonded Copper, respectively.

Next, the compatibility between the stress relaxation and the bonding assurance in the bonding material 2 will be described.

A comparison example of a bonding method using a bonding material having metal nanowires will be described. The metal nanowires are, for example, made of metal material and formed with lengths ranging from several nanometers to several tens of micrometers. For example, in the comparison example, a bonding material is used in which nanowires are formed on both sides of a metal foil, and pressure and heat are applied while the nanowires of the bonding material are respectively in contact with the two members to be bonded. In the comparison example, the two members are joined by forming a high-density sintered joint layer by conducting a heat pressing to the nanowires of the bonding material such that no wire-like portions remain.

According to the inventors' study, cracks occur in the bonding material, when the internal stress becomes large. This is because the elastic modulus of the sintered joint layer in the comparison example is high, when the difference in linear expansion coefficient of the two components to be bonded is a predetermined value or more. The same was true for a bonding material using sinterable nanoparticles. Furthermore, when a bonding material having Cu foil as the metal bulk layer and Cu nanowires as the metal wires is used, cracks are more likely to occur in the bonding material, since the elastic modulus becomes even higher than when Ag is used. When a heat spreader and a semiconductor element are joined using a bonding material containing Cu foil and Cu nanowires, these components are joined by a highly elastic Cu sintered layer. However, cracks occur and progress in the bonding material during the manufacturing process of the semiconductor device. Through careful investigation by the inventors, it has become clear that it is possible to bond two components while suppressing the progression of cracks by deliberately leaving the wire-shaped portion after bonding when the bonding material 2 having the metal wires 221 is used.

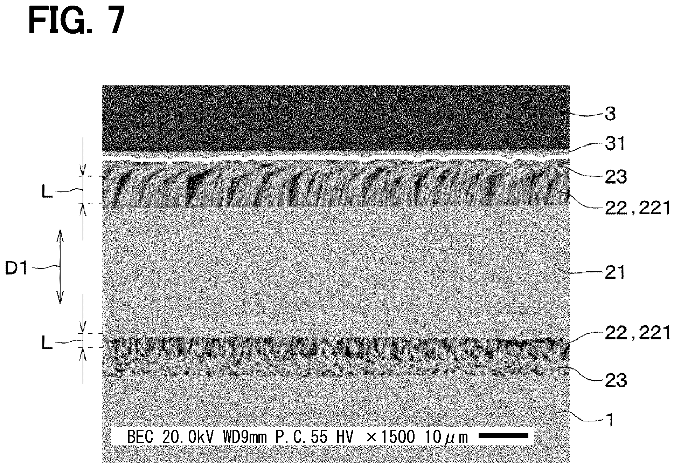

Specifically, as shown in FIG. 7, the bonding material 2 has the stress relaxation layer 22 in which the metal wire 221 remains in a wire shape after bonding, and the sintered joint layer 23 that connects the stress relaxation layer 22 to the member in contact therewith, thereby making it possible to achieve both the stress relief and the secure bonding. FIG. 7 shows the result of observing a cross-section, using a scanning electron microscope (SEM), after the first heat spreader 1 made of Cu and the semiconductor element 3 made of SiC were bonded using the bonding material 2 having the metal bulk layer 21 and the metal wires 221 made of Cu. In the bonding material 2, the internal stress is relaxed and the occurrence of cracks is suppressed by setting the length of the stress relaxation layer 22, i.e., the length of the metal wire 221 in the thickness direction D1 to a predetermined length or more.

For ease of explanation, as shown in FIG. 7, the length of the metal wire 221 remaining in the wire form after bonding in the thickness direction D1 will be referred to as a wire length L. The wire length L corresponds to the length of the stress relaxation layer 22 in the thickness direction D1, that is, the thickness. When the bonding material 2 is configured in such a way that the metal wires 221 are formed on both the front and back surfaces of the metal bulk layer 21, the wire length L means each length of the metal wire 221 on the front or back surface, and is not the sum of these lengths.

Next, Working Examples and Comparative Examples are formed relative to a joint structure in which the first heat spreader 1 and the semiconductor element 3 are joined with each other by the bonding material 2. The results of evaluating the state of crack occurrence in the bonding material 2 will be described in Working Examples and Comparative Examples.

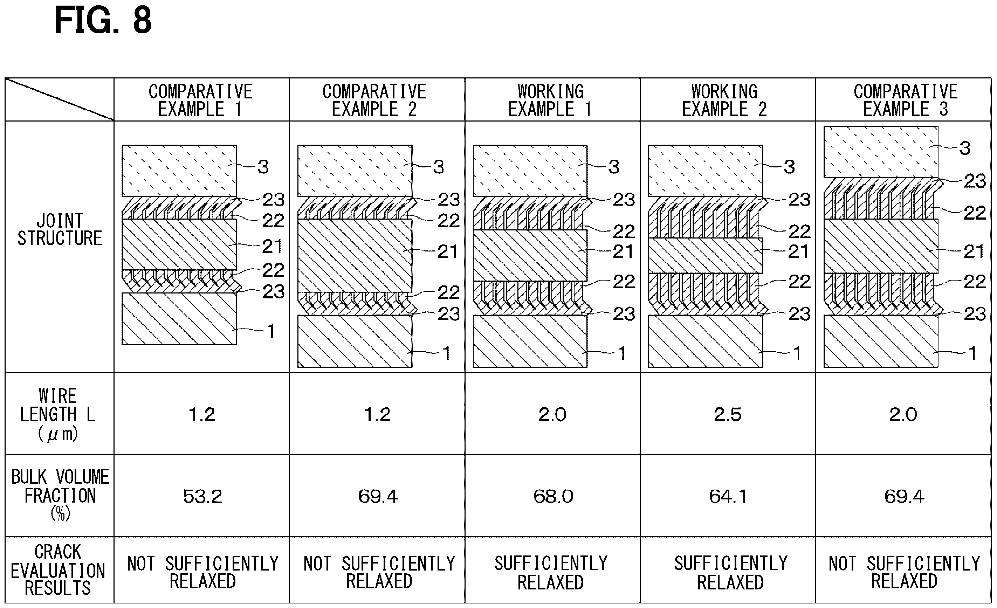

As shown in FIG. 8, in Comparative Examples 1 to 3 and Working Examples 1 and 2, the first heat spreader 1 made of Cu and the semiconductor element 3 made of SiC are bonded together by the bonding material 2 made of Cu having the metal bulk layer 21 and the metal wire 221. Comparative Examples 1 to 3 and Working Examples 1 and 2 were each manufactured by hot pressing, and the sintered joint layer 23 is formed. However, the wire length L or the volume fraction of the metal bulk layer 21 in the bonding material 2 is different among Comparative Examples 1 to 3 and Working Examples 1 and 2.

Hereinafter, for convenience of explanation, the volume fraction of the metal bulk layer 21 in the bonding material 2 will be referred to as a bulk volume fraction. The wire length L and the bulk volume fraction of Comparative Examples and Working Examples can be confirmed and calculated by SEM observation of the cross-section of the sample. The wire length L of the bonding material 2 can be adjusted, for example, by changing the temperature or pressure or both of the heat pressing. The wire length L can also be adjusted by, for example, changing the time of the heat pressing. The bulk volume fraction can be adjusted, for example, by changing the thickness of the metal bulk layer 21 before bonding and the length of the metal wire 221 in the thickness direction D1.

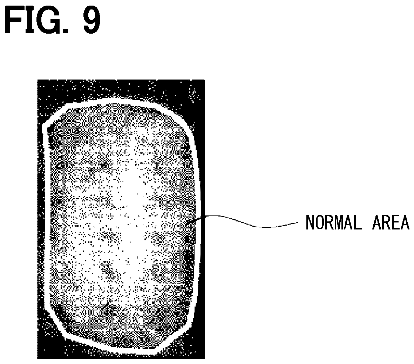

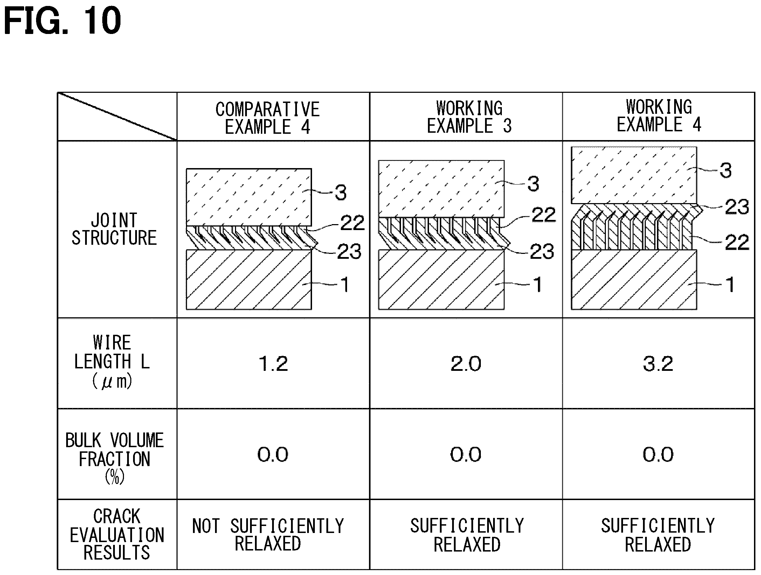

The state of crack in the bonding material 2 after bonding was evaluated by performing ultrasonic testing (SAT). Specifically, the bonded sample is immersed in water, and ultrasonic waves are transmitted from the probe toward the first heat spreader 1. The probe is scanned while receiving the reflected waves. Then, by converting the received reflected waves into an image, for example, an SAT image as shown in FIG. 9 is obtained. In the SAT image shown in FIG. 9, for example, a normal area is represented by a white area, and an abnormal area is represented by a black area. In the normal area, the interface between the bonding material 2 and the semiconductor element 3 has no gaps, i.e., no cracks. Cracks have occurred in the abnormal area. In the crack evaluation shown in FIGS. 8 and 10, when a ratio of the abnormal area in the joint region, i.e., a ratio of the area of the crack occurrence part in the SAT image is 5% or less, it is determined that the stress was sufficiently relaxed. When the ratio of the abnormal area in the joint region is more than 5%, it is determined that the stress was not sufficiently relaxed. Hereinafter, for ease of explanation, the ratio of the area of the crack occurrence part in the joint region of the SAT image may be referred to as a poor area ratio.

In Comparative Examples 1 to 3, the heat pressing was carried out at a temperature of 170°C and a pressure of 20 MPa. In Comparative Example 1, the wire length L was a maximum of 1.2 µm, and the bulk volume fraction was 53.2%. In Comparative Example 2, the wire length L was a maximum of 1.2 µm, and the bulk volume fraction was 69.4%. In Comparative Example 3, the wire length L was a maximum of 2.0 µm, and the bulk volume fraction was 69.4%. In all of Comparative Examples 1 to 3, the poor area ratio exceeded 5%. In other words, the stress relaxation was insufficient since the area ratio of cracks occurring in the bonding material 2 was large.

In contrast, in Working Examples 1 and 2, the heat pressing was carried out at a temperature of 170°C and a pressure of 10 MPa. In Working Example 1, the wire length L was a minimum of 2.0 µm, and the bulk volume fraction was 68.0%. In Working Example 2, the wire length L was a minimum of 2.5 µm and the bulk volume fraction was 64.1%. In both of Working Examples 1 and 2, the poor area ratio was 5% or less. In other words, the area ratio of cracks was small, and the stress relaxation was sufficient. The above results suggest that it is possible to ensure the bonding while suppressing cracks in the bonding material 2 by at least making the wire length L as 2.0 µm or more and the bulk volume fraction as 68% or less, when the bonding material 2 has the metal bulk layer 21 and the stress relaxation layer 22. From the viewpoint of suppressing the crack propagation, there is no particular upper limit to the wire length L. From the viewpoint of reducing the manufacturing costs, the wire length L is preferably 20 µm or less. As will be described later, from the viewpoint of suppressing the occurrence of initial crack, it is desirable that the wire length L is 8 µm or less.

Next, a case where the bonding material 2 does not have the metal bulk layer 21 will be described.

As shown in FIG. 10, in Comparative Example 4 and Working Examples 3 and 4, the first heat spreader 1 made of Cu and the semiconductor element 3 made of SiC are bonded by the bonding material 2 made of the metal wire 221, and the joint structure does not have the metal bulk layer 21.

In Comparative Example 4 and Working Example 3, the metal wires 221 are formed on the back surface 3b of the semiconductor element 3 by electroplating, and then the first heat spreader 1 and the semiconductor element 3 are pressurized and heated. In Working Example 4, the metal wires 221 are formed on the first heat spreader 1 by electroplating, and then the first heat spreader 1 and the semiconductor element 3 are pressurized and heated. In Comparative Example 4 and Working Examples 3 and 4, the bonding material 2 after bonding consists of the stress relaxation layer 22 and the sintered joint layer 23, and the sintered joint layer 23 is formed at the tip of the metal wire 221, but the wire length L is different.

In Comparative Example 4, the heat pressing was performed at a temperature of 170°C and a pressure of 20 MPa. In Comparative Example 4, the wire length L was 1.2 µm at maximum, the poor area ratio exceeded 5%. The area ratio of cracks in the bonding material 2 was large, and the stress relaxation was insufficient.

In contrast, in Working Examples 3 and 4, the heat pressing was carried out at a temperature of 170°C and a pressure of 10 MPa. In Working Examples 3 and 4, the wire length L was 2.0 µm and 3.2 µm, respectively, at minimum. In Working Examples 3 and 4, the poor area ratio was 5% or less. In other words, the area ratio of cracks was small, and the stress relaxation was sufficient. These results suggest that it is possible to ensure the bonding and to suppress the crack progression at the same time, when the sintered joint layer 23 is formed after bonding and the wire length of the stress relaxation layer 22 is 2.0 µm or more, while the bonding material 2 does not have the metal bulk layer 21.

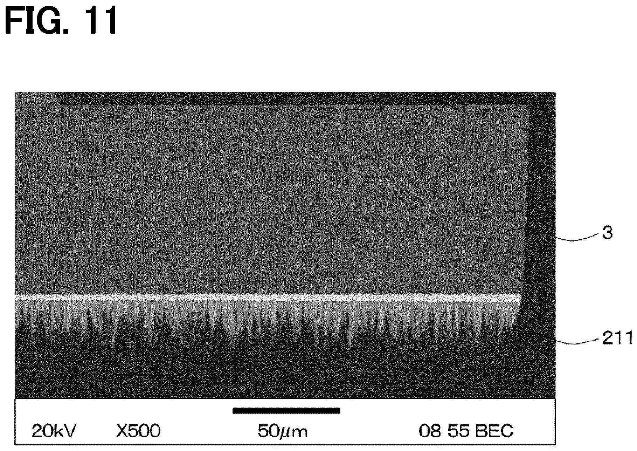

As shown in FIG. 11, when the bonding material 2 does not have the metal bulk layer 21, it is preferable to form the metal wire 221 on the semiconductor element 3, in order to further improve the effect of stress relaxation. As a result, the root of the metal wire 221 is disposed at the interface between the first heat spreader 1 and the semiconductor element 3 where the difference in linear expansion coefficient is greatest, resulting in a joint structure that is more susceptible to stress relaxation. In this way, when the semiconductor element 3 and another member are joined by the bonding material 2 made of the metal wire 221, it is preferable to form the metal wire 221 on the side between the semiconductor element 3 and another member that has a larger difference in linear expansion coefficient. FIG. 11 shows the result of SEM observation relative to a cross-section of a sample in which the metal wires 221 are formed on the semiconductor element 3 made mainly of SiC, prior to bonding with another member.

In Working Examples 1 to 4, the metal wire 221 is Cu nanowire. It is believed that a similar stress relaxation effect can be obtained when the metal wire 221 is made of another metal material. In other words, it possible to ensure the bonding and to suppress cracks, when the bonding material 2 includes the stress relaxation layer 22 having at least a predetermined wire length L and the sintered joint layer 23, after bonding. This applies not only to the structure in which the first heat spreader 1 and the semiconductor element 3 are bonded with the bonding material 2, but also to the structure in which the semiconductor element 3 and another member such as the metal block 4 are bonded with the bonding material 2. The conditions of the heat pressing when bonding the first heat spreader 1 and the semiconductor element 3 with the bonding material 2 are not limited to Working Examples 1 to 4, and can be changed as appropriate depending on the length of the metal wire 221 in the thickness direction D1 before bonding, the constituent materials, and the like.

Next, a description will be given of the relationship between the wire length L of the metal wire 221 and the stress generated at the joint in a first structure corresponding to Working Examples 1 and 2. The stress represents a magnitude of a fracture mechanics parameter (J integral) related to whether an initiated crack will propagate, and a maximum principal stress related to whether a crack will first occur. Below, from the viewpoint of these two types of stress, the relationship between the stress and the wire length L will be described.

In the first structure, the first heat spreader 1 made of Cu and the semiconductor element 3 made of SiC are joined by the bonding material 2 having the metal wires 221 made of Cu and formed on both sides of the metal bulk layer 21 made of Cu. In the following, unless otherwise specified, the thickness refers to a thickness in the thickness direction D1.

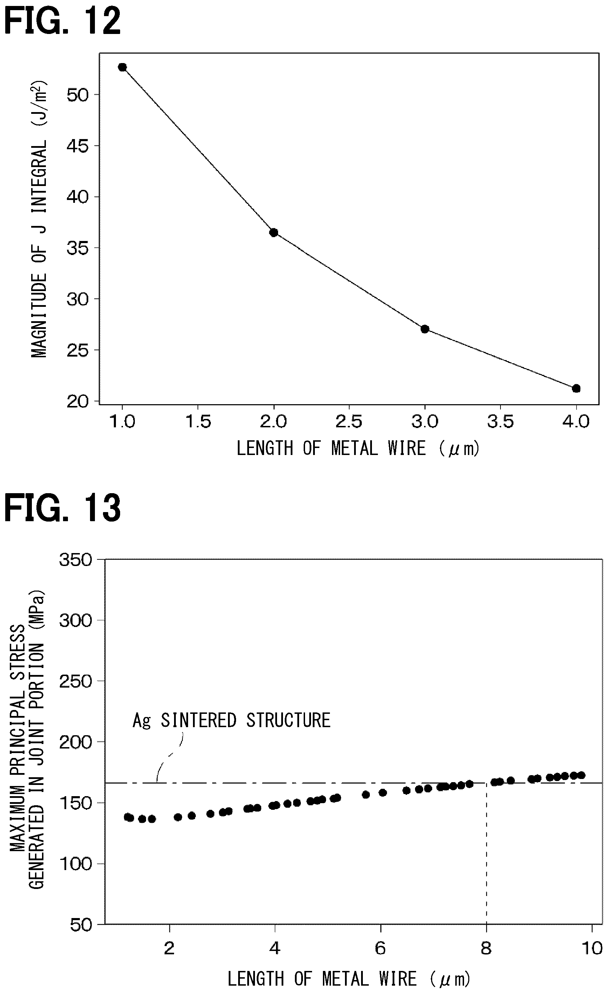

FIG. 12 shows the results of simulation analysis regarding the fracture mechanics parameters (J integral) at the tip of microcrack that has already occurred in the sintered joint layer 23, when the thicknesses of the sintered joint layer 23 and the metal bulk layer 21 are fixed and the wire length L is changed, in the first structure. The J integral is a parameter for evaluating the flow of energy relative to the propagation of crack, and is an energy release rate at the tip of the crack. The simulation can be performed, for example, by using numerical analysis software based on the finite element method. In the analysis, a model was used in which a horizontal crack having a length of 20 µm was introduced as an extremely small crack starting from the end toward the inside of the bonding layer at a position of 0.1 µm vertically downward from the interface between the SiC chip and the sintered joint layer. FIG. 12 shows the results of simulation analysis in which the thickness of the sintered joint layer 23 is fixed at 1 µm, the thickness of the metal bulk layer 21 is fixed at 5 µm, and the wire length L of the metal wire 221 is changed.

It is known that if the magnitude of the J integral is small, the crack growth rate decreases. According to the analysis results of FIG. 12, as the wire length L of the metal wire 221 increases, the magnitude of the J integral at the tip of the crack decreases. This analysis result is consistent with the experimental result shown in FIG. 8, in which the poor area ratio was smaller as the wire length L of the metal wire 221 is larger, from the viewpoint of whether a microcrack that has once occurred will further propagate.

FIG. 13 shows the results of simulation analysis regarding the maximum principal stress generated in the sintered joint layer 23, in the first structure, when the thickness of the sintered joint layer 23 is fixed at 1 µm, the thickness of the metal bulk layer 21 is fixed at 5 µm, and the wire length L of the metal wire 221 is changed. The simulation can be performed, for example, by using numerical analysis software based on the finite element method. For example, the stress was approximately constant at 136 to 138 MPa when the wire length L of the metal wire 221 was 1.23 µm, 1.48 µm, and 1.50 µm. The stress was 139 MPa when the wire length L was 2.18 µm, and increased as the wire length L increases. For example, the stresses were 149 MPa, 159 MPa, 168 MPa, 170 MPa, 171 MPa, and 172 MPa when the wire lengths L were 4.04 µm, 6.05 µm, 8.16 µm, 8.96 µm, 9.20 µm, and 9.80 µm, respectively.

In addition, for an Ag sintered structure in which the bonding material 2 in the first structure was changed to a sintered silver material and the thickness of the bonding layer made of the sintered silver material was 22 µm, the maximum principal stress generated in the joint portion of the sintered layer was calculated by simulation. In FIG. 13, a dashed line represents the calculated stress value of the Ag sintered structure. As a result of the calculation, the stress in the Ag sintered structure was 162 MPa. The Ag sintered structure corresponds to a conventional sintered joint structure that does not have the metal wire 221.

According to the above simulation results, in the first structure, if the wire length L of the metal wire 221 is at least 8 µm or less, the maximum principal stress in the joint portion of the sintered joint layer 23 can be suppressed to be equal to or less than that of the Ag sintered structure. Therefore, from the viewpoint of suppressing the occurrence of the initial crack in the bonding material 2, it is considered preferable that the wire length L of the metal wire 221, that is, the length of the stress relaxation layer 22, is at least 8 µm or less. The value of 8 µm was calculated as the wire length L at which the stress of the Ag sintered structure becomes 162 MPa or less from the mathematical expression of the approximation curve obtained based on the data shown in FIG. 13.

Next, a description will be given of the relationship between the thickness of the sintered joint layer 23 and the maximum principal stress occurring in the bonding portion in a second structure corresponding to Working Example 3.

In the second structure, the metal wire 221 made of Cu is formed on the semiconductor element 3 made of SiC, and the first heat spreader 1 made of Cu is bonded to the semiconductor element 3 using the metal wire 221 as the bonding material 2.

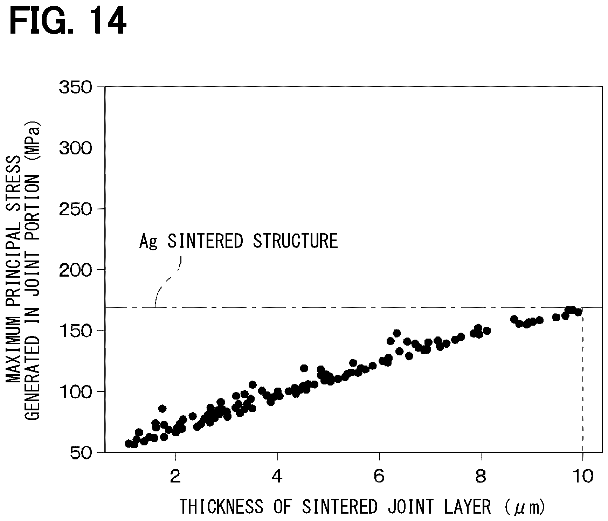

In the second structure, the wire length L of the metal wire 221 was set within a range 2 µm or more and 8 µm or less, and the maximum principal stress generated in the sintered joint layer 23 was investigated by simulation, while the thickness of the sintered joint layer 23 was changed, and the results shown in FIG. 14 were obtained. Although the maximum principal stress varies slightly within the range of thickness of the sintered joint layer 23 from 1.23 µmto 1.50 µm, it was observed that the maximum principal stress tends to increase almost linearly with increasing the thickness. For example, the maximum principal stress was 68 MPa, 96 MPa, 125 MPa, 150 MPa, 158 MPa, and 162 MPa when the thickness of the sintered joint layer 23 was 1.87 µm, 4.05 µm, 6.04 µm, 8.10 µm, 9.06 µm, and 9.98 µm, respectively.

According to the above simulation results, in the second structure, if the thickness of the sintered joint layer 23 is at least 10 µm or less, the maximum principal stress in the bonding portion of the sintered joint layer 23 can be suppressed to be equal to or less than that of the Ag sintered structure. Therefore, from the viewpoint of suppressing the occurrence of initial crack in the bonding material 2, it is considered preferable that the thickness of the sintered joint layer 23 is at least 10 µm or less. The value of 10 µm was calculated as the thickness of the sintered joint layer 23 such that the stress of the Ag sintered structure is 162 MPa or less from the mathematical expression of the approximation curve obtained based on the data shown in FIG. 14.

According to this embodiment, in the semiconductor device 100, the semiconductor element 3 as a first member and the second member are bonded with the bonding material 2, and the bonding material 2 has the stress relaxation layer 22 composed of the metal wires 221 and the sintered joint layer 23 bonded to the semiconductor element 3 or the second member. The bonding material 2 secures the bonding between the semiconductor element 3 and the second member by the sintered joint layer 23, while the stress caused by the difference in linear expansion coefficient between the two members is relaxed, since the wire length L of the metal wire 221 after bonding is equal to or longer than a predetermined value. Therefore, the semiconductor device 100 ensures the bonding between the semiconductor element 3 and the second member while suppressing the progression of cracks caused by the difference in linear expansion coefficient between these members, thereby improving reliability. The semiconductor device 100 also has the following features.
(1) In the semiconductor device 100, a portion of the metal wire 221 of the bonding material 2 is oriented along the thickness direction D1, and another portion of the metal wire 221 is oriented at an angle of a predetermined value or more relative to the thickness direction D1.
(2) In the semiconductor device 100, the wire length L in the bonding material 2 after bonding is 2.0 µm or more.
(3) In the semiconductor device 100, the length of the stress relaxation layer 22 in the thickness direction D1 is 8 µm or less. The thickness of the sintered joint layer 23 in the thickness direction D1 is 10 µm or less. As a result, the stress generated in the bonding material 2 can be reduced compared with a case of a conventional Ag sintered structure using sintered silver. Accordingly, the bonding reliability is improved.
(4) In the semiconductor device 100, the bonding material 2 has the metal bulk layer 21 and the bulk volume fraction is 68% or less.
(5) In the semiconductor device 100, the metal wires 221 of the bonding material 2 are Cu nanowires. This reduces the material costs compared to a case where the metal wire 221 is made of other sinterable materials such as Ag.
(6) In the semiconductor device 100, the metal bulk layer 21 is made of one of Cu, Al, and Cu alloy. This allows the metal wires 221 to be formed by electroplating using the metal bulk layer 21 as a base, thereby reducing the manufacturing cost of the bonding material 2. Accordingly, the manufacturing cost of the semiconductor device 100 can be reduced.
(7) In the semiconductor device 100, the semiconductor element 3 or/and the second member has the covering layer 11, 31, 41 made of Cu, Ag, or Cu alloy, and the covering layer 11, 31, 41 is bonded to the bonding material 2. This allows the sintered joint layer 23 to be more stably formed at the interface between the metal wire 221 of the bonding material 2 and the semiconductor element 3 or the second member, improving the bonding property.

Although the present disclosure has been described in accordance with the embodiment, it is understood that the present disclosure is not limited to such embodiment or structure. The present disclosure also includes various modifications and modifications within an equivalent range. In addition, various combinations and modes, and further, other combinations and modes including one element of these alone, or thereabove, or therebelow, are also comprised within the scope or concept range of the present disclosure.

The constituent element(s) of each of the above embodiments is/are not necessarily essential unless it is specifically stated that the constituent element(s) is/are essential in the above embodiment, or unless the constituent element(s) is/are obviously essential in principle. A quantity, a value, an amount, a range, or the like referred to in the description of the embodiments described above is not necessarily limited to such a specific value, amount, range or the like unless it is specifically described as essential or understood as being essential in principle. Further, in each of the embodiments described above, when referring to the shape, positional relationship, and the like of the components and the like, the shape and relationship are not limited to the shape, positional relationship, and the like, except for the case where the shape and the positional relationship are specifically specified, the case where the shape and the positional relationship are fundamentally limited to a specific shape, positional relationship, and the like.

### (Various Aspects of Present Disclosure)

The present disclosure described above can be understood from the following viewpoints. As a first viewpoint, a semiconductor device includes: a semiconductor element as a first member; a second member connected to the semiconductor element; and a bonding material bonding the semiconductor element and the second member. The bonding material has a stress relaxation layer made of metal wires and a sintered joint layer bonded to the semiconductor element or the second member. The metal wire has a length in a thickness direction defined to connect the semiconductor element and the second member, and the length is a predetermined value or more. As a second viewpoint, in the semiconductor device according to the first viewpoint, the bonding material is set such that a part of the metal wire is oriented along the thickness direction and another part of the metal wire is oriented at an angle of a predetermined value or more with respect to the thickness direction. As a third viewpoint, in the semiconductor device according to the first or second viewpoint, the bonding material is set such that the length of the stress relaxation layer in the thickness direction is 2 µm or more. As a fourth viewpoint, in the semiconductor device according to the third viewpoint, the bonding material is set such that a length of the stress relaxation layer in the thickness direction is 8 µm or less. As a fifth viewpoint, in the semiconductor device according to the third or fourth viewpoint, the bonding material is set such that a thickness of the sintered joint layer in the thickness direction is 10 µm or less. As a sixth viewpoint, in the semiconductor device according to any one of the first to fifth viewpoints, the bonding material further has a metal bulk layer, and the metal bulk layer has a volume fraction of 68% or less in the bonding material. As a seventh viewpoint, in the semiconductor device according to any one of the first to sixth viewpoints, the metal wire is a nanowire made of copper. As an eighth viewpoint, in the semiconductor device according to the sixth viewpoint, the metal bulk layer is made of any one of copper, aluminum, and copper alloy. As a ninth viewpoint, in the semiconductor device according to the eighth viewpoint, the semiconductor element and the second member have a covering layer bonded to the bonding material, and the covering layer is made of any one of copper, silver, and copper alloy.

## Claims

1. A semiconductor device comprising:
a semiconductor element (3) as a first member;
a second member (1, 4) connected to the semiconductor element; and
a bonding material (2) that bonds the semiconductor element and the second member, wherein
the bonding material has:
a stress relaxation layer (22) made of a plurality of metal wires (221); and
a sintered joint layer (23) bonded to the semiconductor element or the second member, and
the metal wire has a length equal to or greater than a predetermined value in a thickness direction (D1) defined to connect the semiconductor element and the second member.

2. The semiconductor device according to claim 1, wherein
a portion of the metal wires is oriented along the thickness direction, and another portion of the metal wires is oriented at an angle of at least a predetermined value with respect to the thickness direction, in the bonding material.

3. The semiconductor device according to claim 1 or 2, wherein
a length of the stress relaxation layer in the thickness direction is 2 µm or more.

4. The semiconductor device according to claim 3, wherein a length of the stress relaxation layer in the thickness direction is 8 µm or less.

5. The semiconductor device according to claim 3 or 4, wherein a thickness of the sintered joint layer in the thickness direction is 10 µm or less.

6. The semiconductor device according to any one of claims 1 to 5, wherein
the bonding material further has a metal bulk layer (21), and
the metal bulk layer has a volume fraction of 68% or less in the bonding material.

7. The semiconductor device according to any one of claims 1 to 6, wherein the metal wire is a nanowire made of copper.

8. The semiconductor device according to claim 6, wherein the metal bulk layer is made of one of copper, aluminum, and copper alloy.

9. The semiconductor device according to claim 8, wherein
at least one of the semiconductor element or the second member has a covering layer (11, 31, 41) bonded to the bonding material, and
the covering layer is made of one of copper, silver, and copper alloy.
